(19) Europäisches Patentamt
European Patent Office
Office européen des brevets

(11) **EP 2 333 643 A1**

(12) **EUROPEAN PATENT APPLICATION**
published in accordance with Art. 153(4) EPC

(43) Date of publication:
**15.06.2011 Bulletin 2011/24**

(51) Int Cl.:
*G06F 3/041* (2006.01)   *G02F 1/133* (2006.01)
*G09G 3/20* (2006.01)   *G09G 3/36* (2006.01)
*H01L 31/10* (2006.01)   *H04N 5/335* (2011.01)

(21) Application number: **09817551.6**

(22) Date of filing: **09.06.2009**

(86) International application number:
**PCT/JP2009/060551**

(87) International publication number:
**WO 2010/038513 (08.04.2010 Gazette 2010/14)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **30.09.2008 JP 2008254401**

(71) Applicant: **Sharp Kabushiki Kaisha**
**Osaka-shi, Osaka 545-8522 (JP)**

(72) Inventors:
• **SHIRAKI, Ichiro**
  **Osaka-shi, Osaka 545-8522 (JP)**
• **MAEDA, Kazuhiro**
  **Osaka-shi, Osaka 545-8522 (JP)**
• **SUGIYAMA, Hiroaki**
  **Osaka-shi, Osaka 545-8522 (JP)**

(74) Representative: **Goddar, Heinz J.**
**Forrester & Boehmert**
**Pettenkoferstrasse 20-22**
**80336 München (DE)**

(54) **DISPLAY DEVICE**

(57)   Provided is a display device including a sensor row driver (6) which sequentially outputs a read-out signal (RW) for causing each pair of picture element area groups, which includes both a first picture element area (PIX1) and a second picture element area (PIX2) as detection picture element areas and is made up of two picture element rows, to simultaneously output a photodetection signal of each of the first picture element areas (PIX1) and a dark current detection signal of each of the second picture element areas (PIX2). In each pair of the picture element area groups, outputs of the detection picture element areas are connected to different output lines (RSL1, RSL2).

FIG. 1

Printed by Jouve, 75001 PARIS (FR)

EP 2 333 643 A1

## Description

Technical Field

The present invention relates to a display device including a photosensor in a display region.

Background Art

There has been a liquid crystal display device including a photosensor in a pixel circuit. Attempts have been made to apply this configuration to a fingerprint authentication technique and a touch panel.

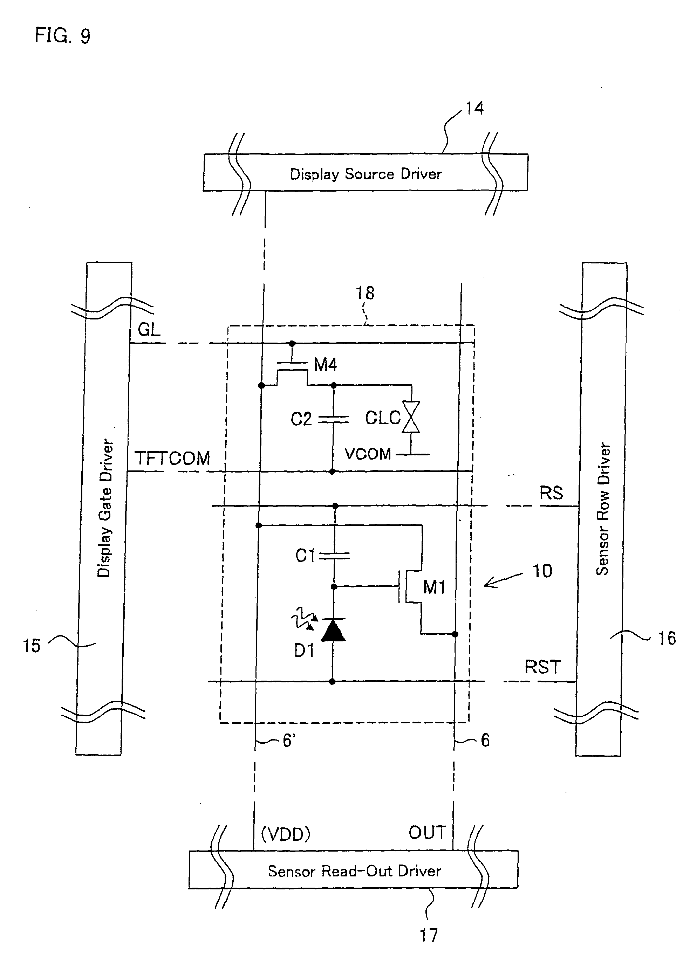

Fig. 9 shows a configuration of a display region included in such a display device and circuit blocks driving the display region, which are disclosed in Patent Literature 1.

In the display region, a pixel 18 constituting an array includes a sensor circuit 10, in addition to a display circuit made up of a liquid crystal capacitor CLC, a storage capacitor C2, a TFT M4, etc. The sensor circuit 10 includes an n-channel amplifying TFT M1, a photosensor D1, and a capacitor C1.

In the display circuit, a gate of the TFT M4 is connected to a gate line GL, and a source of the TFT M4 is connected to a data line 6'. The liquid crystal capacitor CLC is formed between a pixel electrode which is connected to a drain of the TFT M4 and a common electrode to which a common voltage VCOM is applied. The storage capacitor C2 is formed between the pixel electrode and a common line TFTCOM.

The gate line GL and the common line TFTCOM are driven by a gate driver 15, and the data line 6' is driven by a source driver 14.

In the sensor circuit 10, a cathode of the photosensor D1 and one end of the capacitor C1 are connected to each other. A gate of the amplifying TFT M1 is connected to a node between the photosensor D1 and the capacitor C1. A drain of the amplifying TFT M1 is connected to the data line 6', and a source of the amplifying TFT M1 is connected to a sensor output line 6. During a sensor drive period which is set except during a time period for writing a data signal, the data line 6' is driven by a sensor read-out driver 17 via a switch (not illustrated). A voltage of the sensor output line 6 is read by the sensor read-out driver 17.

An anode of the photosensor D1 is connected to a reset line RST. The other end of the capacitor C1 is connected to a row select line RS. The reset line RST and the row select line RS are driven by a sensor row driver 16.

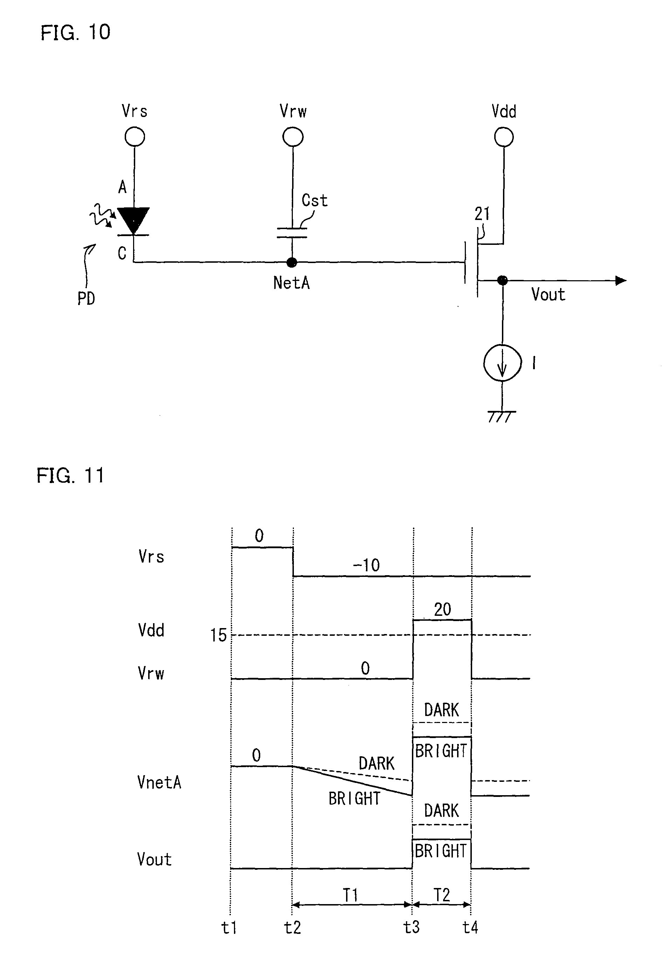

Fig. 10 shows a specific circuit configuration of the sensor circuit 10 in detail. A drain of the amplifying TFT 21 (which corresponds to the amplifying TFT M1 of Fig. 9) is connected to the data line 6', and a voltage Vdd is applied thereto by the sensor read-out driver 17 during the sensor drive period. From a source of the amplifying TFT 21, a sensor output voltage Vout is supplied to the sensor output line 6. The source of the amplifying TFT 21 is also connected to a constant current source I that is separately provided in an IC or the like.

The photosensor PD is a pin photodiode. To an anode A of the photosensor PD, a voltage Vrs is applied from the reset line RST.

A capacitor Cst (which corresponds to the capacitor C1 of Fig. 9) has one terminal connected to a gate of the amplifying TFT 21 and the other terminal to which a voltage Vrw is applied from the row select line RS.

A point where the gate of the amplifying TFT 21, a cathode C of the photosensor PD, and the one terminal of the capacitor Cst are connected one another is referred to as a node NetA.

Now, an operation of the sensor circuit 10 having the foregoing configuration is described with reference to Fig. 11.

During the sensor drive period, the data line 6' is disconnected from the source driver 14 and connected to the sensor read-out driver 17. At an initial timing t1 of the sensor drive period, the sensor row driver 16 sets the voltage Vrs to a high level (here, 0V) so as to supply the reset line RST with an initialization signal. This causes the photosensor PD to be conductive in a forward direction to set a potential VnetA at the node NetA to a high level (here, 0V). At this time, the voltage Vrw to be applied from the sensor row driver 16 to the row select line RS is set to a low level (here, 0V). The voltage Vdd to be applied from the sensor read-out driver 17 to the data line 6' is set to 15V DC voltage.

Subsequently, at a timing t2, the sensor row driver 16 sets the voltage Vrs to a low level (here, - 10V). Then, in the photosensor PD, a potential at the anode A becomes lower than a potential at the cathode C, thereby causing the photosensor PD to be subjected to reverse bias.

At the timing t2, a charge period T1 begins. During the charge period T1, the node NetA is charged in accordance with an intensity of light irradiating the photosensor PD. When the photosensor PD is irradiated with light, a leakage current that flows from the cathode C toward the anode A varies depending on the intensity of the irradiated light. In a bright section, the anode A, i.e., the potential VnetA is rapidly decreased due to a large leakage current, while in a dark section, a small leakage current causes the potential VnetA to be slowly decreased.

At a timing t3 at which the charge period T1 terminates, the sensor row driver 16 sets the voltage Vrw to a high level (here, 20V), thereby supplying the row select line RS with a read-out signal. In consequence, a capacitive coupling provided by the capacitor Cst causes the potential VnetA to be increased from a negative potential to a positive potential. As such, a potential difference between the bright section and the dark section is maintained. Thereby, the amplifying TFT 21 becomes conductive so as to start an output period T2 of a sensor output at the timing t3.

A total capacitor value Ctotal of the sensor circuit and the capacitor Cst has a following relationship:

$$\alpha = Cst/Ctotal$$

whereas a rise ΔVnetA of the potential VnetA caused by the voltage Vrw is represented as follows:

$$\Delta VnetA = \alpha \times Vrw_{p\text{-}p,}$$

where $Vrw_{p\text{-}p}$ is a peak-to-peak voltage of Vrw and is 20V in the above example.

The output voltage Vout depends on the potential VnetA and is represented by:

$$Vout \approx VnetA - Vth - (2 \times I/\beta)^{1/2}$$

where Vth is a threshold voltage of the amplifying TFT 21, β is a conductance of the amplifying TFT 21, and I is a current of the constant current source I. Therefore, reading out the output voltage Vout by the sensor read-out driver 17 during the output period T2 allows detecting the sensor output of the photosensor PD, i.e., the intensity of light irradiating the photosensor PC.

At a timing t4 at which the output period T2 terminates, the sensor row driver 16 sets the voltage Vrw to a low level (here, 0V), and completes the sensor drive period.

Citation List

[Patent Literature]

[Patent Literature 1]
PCT International Publication WO2007/145347 (Publication date: December 21, 2007)
[Patent Literature 2]
Japanese Patent Application Publication Tokukaihei No. 1-164165 A (1989) (Publication date: June 28, 1989)
[Patent Literature 3]
Japanese Patent Application Publication Tokukai No. 2007-47991 A (Publication date: February 22, 2007)

Summary of Invention

Technical Problem

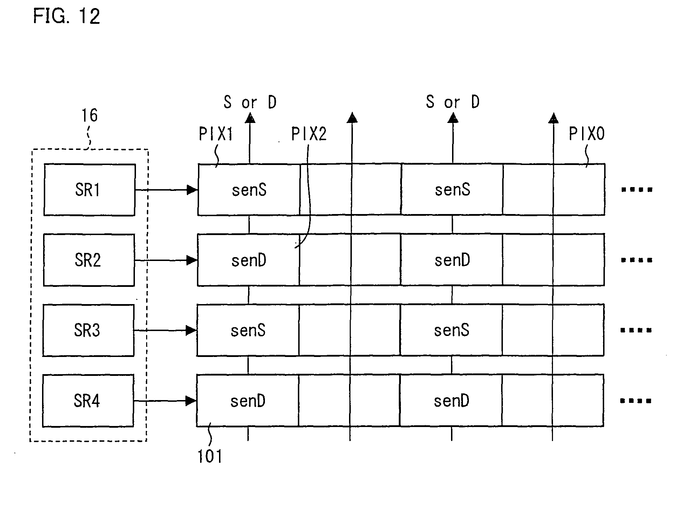

Fig. 12 shows a layout example of the sensor circuits described above.

The sensor circuits are the photosensors PD. Outputs of the photosensor PD contain a photocurrent component which is dependent on the irradiated light and a dark current component which is primarily dependent on temperature. As such, even under the same intensity of the irradiated light, a difference in temperature causes a difference in an output value. This makes it impossible to detect a correct intensity of the irradiated light. On this account, two types of sensor circuits, i.e., (i) photodetection circuits senS that produce detection outputs of the irradiated light and (ii) dark current detection circuits senD that produce detection outputs of the dark current are provided as the sensor circuits, so that the detection outputs from the photodetection circuits senS are compensated by the detection outputs from the dark current detection circuits senD, thereby allowing a correct intensity of the irradiated light to be found.

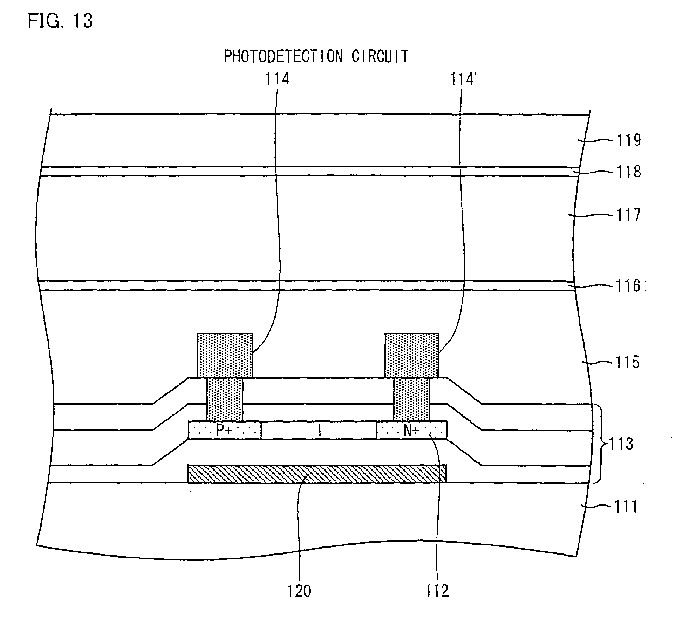

Fig. 13 is a cross sectional view of a panel including a device structure of the photosensor PD.

On a transparent substrate 111 which serves as a TFT substrate, a light blocking film 120, a semiconductor layer 112, an insulating film 113, a metal wiring 114, a planarizing film 115, a transparent electrode 116, a liquid crystal layer 117, a transparent electrode 118, and a counter substrate 119 are stacked in order. The semiconductor layer 112 that configures the pin photodiode has a $P^+$ region, an I region, and an $N^+$ region that are made of Si. The metal wiring 114, which serves as an anode electrode, contacts the $P^+$ region via a contact hole provided in the insulating film 113. The metal wiring 114', which serves as a cathode electrode, contacts the $N^+$ region via a contact hole provided in the insulating film 113.

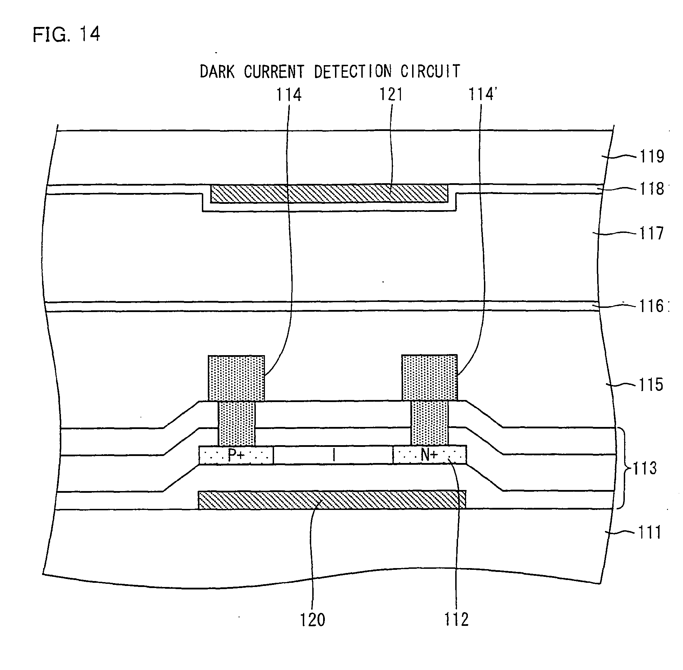

Meanwhile, as shown in Fig. 14, the dark current detection circuit senD includes, on a side of the counter substrate 119, a light blocking film 121 that blocks light in order to detect the dark current of the pin photodiode. A difference in configurations of the dark current detection circuit senD and the photodetection circuit senS lies in whether or not this light blocking film 121 is provided.

It is necessary for the dark current detection circuits senD to produce reference outputs of the photodetection circuits senS. As such, the photodetection circuit senS and the dark current detection circuit senD that make up a pair for an output compensation are arranged in proximity to each other. For example, as shown in Fig. 12, the photodetection circuit senS and the dark current detection circuit senD that make up the pair are adjacently aligned in a column direction. Each of the photodetection circuits senS and the dark current detection circuits senD is provided in a region composed of a predetermined number of picture elements. For instance, each of the photodetection circuits senS and the dark current detection circuits senD is provided to one pixel made up of three picture elements of R, G, and B. One photodetection circuit senS is included in a first pixel PIX1, and one dark current detection circuit senD is included in a second pixel PIX2.

In terms of displaying, these photodetection circuits senS and dark current detection circuits senD cause a decrease in an aperture ratio of the display region. As such, they are usually arranged certain distances apart from each other on the display region, and normal pixels PIX0, which do not include the sensor circuits, are interposed between the respective photodetection circuits senS and the respective dark current detection circuits senD. However, for a purpose of improving sensitivity to the irradiated light, in some cases, the normal pixels PIX0 are provided with second photodetection circuits and second dark current detection circuits each having at least a photodiode.

The photodetection circuit senS and the dark current detection circuit senD that make up the pair are line-sequentially reset and read-out by the sensor row driver 16 composed of shift registers. As a consequence, the detection outputs of the photodetection circuit senS and the dark current detection circuit senD are read-out during respective time periods.

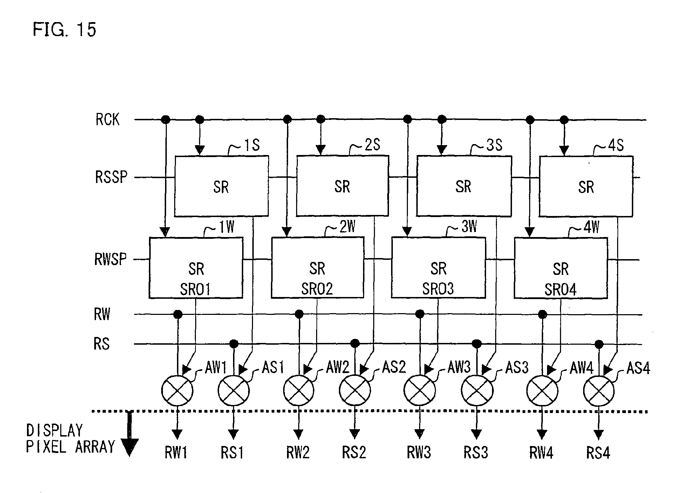

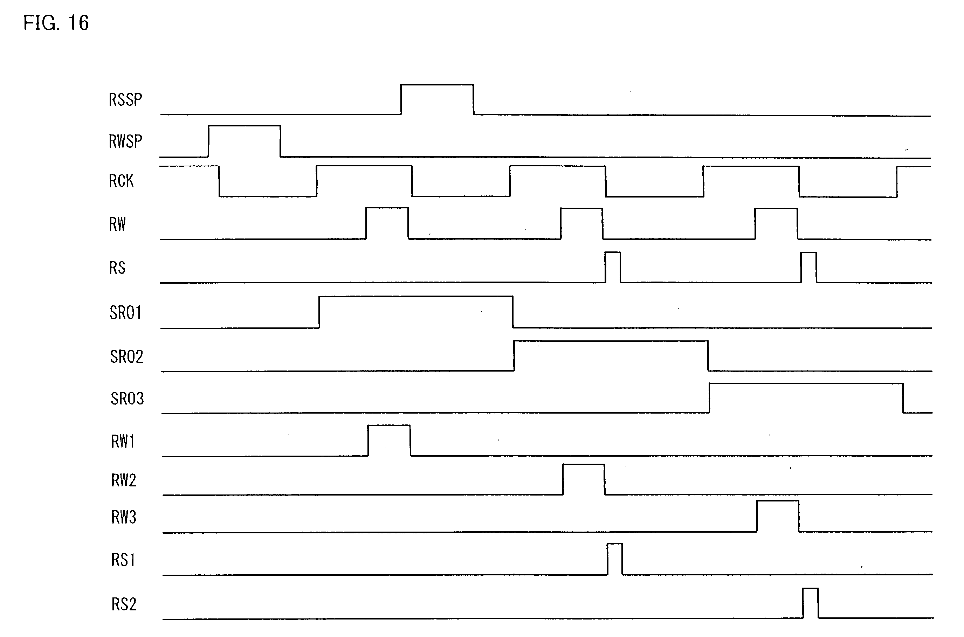

Fig. 15 shows a configuration of the shift registers of the sensor row driver 16. Fig. 16 shows a timing chart describing operations of the shift registers.

The shift registers have two cascades: a first cascade is made up of shift register stages 1 W, 2W, ... generating and outputting read-out signals, and a second cascade is made up of shift register stages 1S, 2S, ... generating and outputting reset signals. Each of the shift register cascades performs a shift operation in response to a clock signal RCK. In the first cascade, after a shift of a start pulse RWSP, sequential shift outputs SRO1, SRO2, ... from the shift register stages 1W, 2W, ... sequentially turns on switches AW1, AW2, .... . Then, high read-out signals RW are sequentially supplied as read-out signals RW1, RW2, ... to a read-out signal supply line. In the second cascade, after a shift of a start pulse RSSP, sequential shift outputs from the shift register stages 1S, 2S, ... sequentially turns on switches AS1, AS2, .... Then, high reset signals RS are sequentially supplied as reset signals RS1, RS2, ... to a reset signal supply line.

The read-out signals RW1, RW2, ... are outputted except during a display selection period of a picture element. The output of reset signals RS1, RS2, ... precedes the read-out by one frame period.

In a conventional display device including the aforementioned sensor circuits, the photodetection circuit senS and the dark current detection circuit senD paired with each other output their detection outputs during different time periods due to sequential scanning. This means that the compensation is carried out by use of the photodetection outputs and dark current detection outputs with the variations due to the time difference. On this account, it is preferable that a reference photodiode in the same environment be used to compensate a light intensity to be detected. In the aforementioned conventional display device, an environment in which the dark current detection circuit senD performs a dark current detection is prone to be different from an environment in which the photodetection circuit senS performs a photodetection. This causes a problem that a correct compensation for a photodetection is not possible.

The present invention has been achieved in view of the above conventional problem, and an object of the present invention is to realize such a display device including a photosensor circuit that is capable of an exact correction of a photodetection result in which different types of data are combined. The correction includes, for example, a correct compensation for a purpose of photodetection.

Solution to Problem

In order to achieve the above object, a display device of the present invention includes a display region in which a plurality of picture elements are arranged in matrix, and in the display device of the present invention, picture element areas are formed in the display region, wherein the each picture element area includes a predetermined number of picture elements on an identical row and is provided with a photosensor for outputting a detection signal indicative of intensity of irradiated light irradiated on the photosensor; at least one pair of picture element area groups is provided, wherein one of the picture element area groups is a first picture element area group and includes picture element areas on one row, and the other one of the picture element area groups is a second picture element area group and includes picture element areas on another row; and each of the at least one pair of picture element area groups is paired such that it is possible to drive the first picture element area group and the second picture element area group simultaneously, and it is possible to output the detection signals of the first picture element area group and the detection signals of the second picture element area group simultaneously.

With the above invention, the first picture element area group and the second picture element area group of each pair of picture element groups are simultaneously driven, and detection outputs of the photosensor circuits are simultaneously obtained from the first picture element area group and the second picture element area group. This makes it possible to obtain two pieces of data with small variations between the first picture element area group and the second picture element area group, which variations are caused by time difference. It is further possible to obtain data with smaller variations by averaging detection outputs that are simultaneously obtained from a plurality of picture element areas having the same structures.

Unlike a case where the first picture element area group and the second picture element area group are alternately driven for one period in turn, in each pair of picture element area groups, one operation is carried out for two drive periods. This can ensure a long read-out time together with a long reset period for the photosensor circuit. As such, it is possible to suppress variations in detection.

By combining the two pieces of data thus obtained with each other, one of the two pieces of data can be exactly corrected by the other. For example, a photodetection result can be correctly compensated by a dark current detection result.

The above configuration can realize such a display device including a photosensor circuit that can exactly correct the photodetection result in which different types of data are combined. For example, the display device can carry out a correct compensation for photodetection.

In order to achieve the above object, in the display device of the present invention, the plurality of picture element areas include detection picture element areas of two types, one of which is a first picture element area type including a photodetection circuit which serves as a photosensor circuit having a photosensor that outputs, as the detection signal, a photodetection signal indicative of intensity of irradiated light irradiated on the photosensor, the photodetection circuit being disposed in a region including a first predetermined number of picture elements, and the other one of which is a second picture element area type including a dark current detection circuit which serves as a photosensor circuit having a photosensor that outputs, as the detection signal, a dark current detection signal of the photosensor, the dark current detection circuit being disposed in a region including a second predetermined number of picture elements, and in the display device of the present invention, the detection signals of the detection picture element areas are outputted via output lines each passing the detection picture element areas aligned in column directions; the display device further comprises light intensity finding means for finding the intensity of the irradiated light by detecting the detection signal of the detection picture element area, the detection signal being supplied to the light intensity finding means via the output line; the at least one pair of the picture element area groups includes both the first picture element area type and the second picture element area type; a sensor row driver for sequentially supplying the at least one pair of picture element area groups with a read-out signal for causing the picture element areas of the first picture element area type and the picture element areas of the second picture element area type to simultaneously output the photodetection signal and the dark current detection signal, respectively; and the at least one pair of picture element area groups is such that one of the picture element area groups and the other one of the picture element area groups are connected with different ones of the output lines, respectively.

With the above invention, the sensor row driver sequentially supplies the read-out signal to each pair of picture element area groups including two types of detection picture element areas, which are the first picture element area type and the second picture element area type, so as to cause the pair of picture element area groups to simultaneously output the photodetection signal of the first picture element area type and the dark current detection signal of the second picture element area type, respectively. In each pair of picture element area groups, the detection signals are supplied to the output lines and obtained. The output lines are provided so as to be connected with a plurality of the detection picture element areas arranged in a column direction. The detection signals thus obtained are detected by the light intensity finding means to find the intensity of light irradiation.

Accordingly, it is possible to perform a correct compensation for photodetection by use of a photodetection signal and a dark current detection signal that are simultaneously obtained and have small variations.

In order to achieve the above object, in the display device of the present invention, the detection picture element areas are arranged in the display region so as not to be adjacent to each other in both a row direction and a column direction.

With the above invention, the photosensors are so sparsely arranged that one photosensor circuit is provided for a plurality of detection picture element areas. This produces an effect that the aperture ratio of the picture elements is not very much decreased.

In order to achieve the above object, in the display device of the present invention, the detection picture element areas of the first picture element area type and the detection picture element areas of the second picture element area type are adjacent to each other in a diagonal direction in each of the at least one pair of picture element area groups.

With the above invention, the first picture element area type and the second picture element area type that make up a pair for compensating the photodetections can be adjacently arranged without decreasing the aperture ratio of the picture elements very much.

In order to achieve the above object, in the display device of the present invention, the first predetermined number and the second predetermined number are equal to each other.

With the above invention, the first picture element area type and the second picture element area type equal out in size. This can easily provide a great freedom in arrangement and a good balance of layout in the display region.

In order to achieve the above object, in the display device of the present invention, the first predetermined number of picture elements and the second predetermined number of picture elements are 3 and the picture elements are respectively three picture elements of R, G, and B.

With the above invention, in a display device in which a pixel is made up of three picture elements of R, G, and B, each of the first picture element area type and the second picture element area type can be composed of one pixel.

In order to achieve the above object, in the display device of the present invention, each of the output lines is a data signal line connected to one of each picture elements included in that one of the detection picture element areas which corresponds to the output line.

With the above invention, the data signal line serves also as the output line of the detection result. This allows that the aperture ratio in the display region is not likely to be decreased.

In order to achieve the above object, in the display device of the present invention, each of the detection picture element areas includes more than one picture element, and each of the detection picture element areas is such that another one of the picture elements included therein is connected with a data signal line serving as a power supply line for outputting the detection signal of the detection picture element area.

With the above invention, the data signal line serves also as the power supply line. Because of this, the aperture ratio in the display region becomes unlikely to be decreased.

In order to achieve the above object, in the display device of the present invention, the sensor row driver includes a first shift register sequentially supplying each of the at least one pair of picture element area groups with the read-out signal. The first shift register may cause switches corresponding to respective shift register stages to be turned on in response to outputs of the respective shift register stages, so that the each of the at least one pair of picture element area groups is sequentially supplied with the read-out signal via corresponding one of the switches.

With the above invention, each shift register stage of the first shift register is commonly used for two picture element rows. As a result, it becomes possible to decrease a circuit scale of the first shift register by half.

In order to achieve the above object, in the display device of the present invention, the sensor row driver includes a second shift register for sequentially supplying each of the at least one pair of the picture element area groups with a reset signal, and the reset signal initializes a detection operation of the detection picture element areas. The second shift register may cause switches corresponding to respective shift register stages to be turned on in response to outputs of the respective shift register stages, so that the each of the at least one pair of picture element area groups is sequentially supplied with the read-out signal via corresponding one of the switches.

With the above invention, each shift register stage of the second shift register is commonly used for two picture element rows. As a result, it becomes possible to decrease a circuit scale of the second shift register by half.

Advantageous Effects of Invention

As described above, a display device of the present invention includes a display region in which a plurality of picture elements are arranged in matrix, and in the display device, picture element areas are formed in the display region, wherein the each picture element area includes a predetermined number of picture elements on an identical row and is provided with a photosensor for outputting a detection signal indicative of intensity of irradiated light irradiated on the photosensor; at least one pair of picture element area groups is provided, wherein one of the picture element area groups is a first picture element area group and includes picture element areas on one row, and the other one of the picture element area groups is a second picture element area group and includes picture element areas on another row; and each of the at least one pair of picture element area groups is paired such that it is possible to drive the first picture element area group and the second picture element area group simultaneously, and it is possible to output the detection signals of the first picture element area group and the detection signals of the second picture element area group simultaneously.

With the above configuration, it becomes possible to realize such a display device including a photosensor circuit that is capable of an exact correction of a photodetection result in which different types of data are combined.

The correction includes, for example, a correct compensation for a purpose of photodetection.

Further, as described above, in the display device of the present invention, the plurality of picture element areas include detection picture element areas of two types, one of which is a first picture element area type including a photodetection circuit which serves as a photosensor circuit having a photosensor that outputs, as the detection signal, a photodetection signal indicative of intensity of irradiated light irradiated on the photosensor, the photodetection circuit being disposed in a region including a first predetermined number of picture elements, and the other one of which is a second picture element area type including a dark current detection circuit which serves as a photosensor circuit having a photosensor that outputs, as the detection signal, a dark current detection signal of the photosensor, the dark current detection circuit being disposed in a region including a second predetermined number of picture elements, and in the display device of the present invention, the detection signals of the detection picture element areas are outputted via output lines each passing the detection picture element areas aligned in column directions; the display device further comprises light intensity finding means for finding the intensity of the irradiated light by detecting the detection signal of the detection picture element area, the detection signal being supplied to the light intensity finding means via the output line; the at least one pair of the picture element area groups includes both the first picture element area type and the second picture element area type; a sensor row driver for sequentially supplying the at least one pair of picture element area groups with a read-out signal for causing the picture element areas of the first picture element area type and the picture element areas of the second picture element area type to simultaneously output the photodetection signal and the dark current detection signal, respectively; and the at least one pair of picture element area groups is such that one of the picture element area groups and the other one of the picture element area groups are connected with different ones of the output lines, respectively.

Accordingly, it becomes possible to perform a correct compensation for photodetection by use of a photodetection signal and a dark current detection signal that are simultaneously obtained and have small variations.

Brief Description of Drawings

Fig. 1

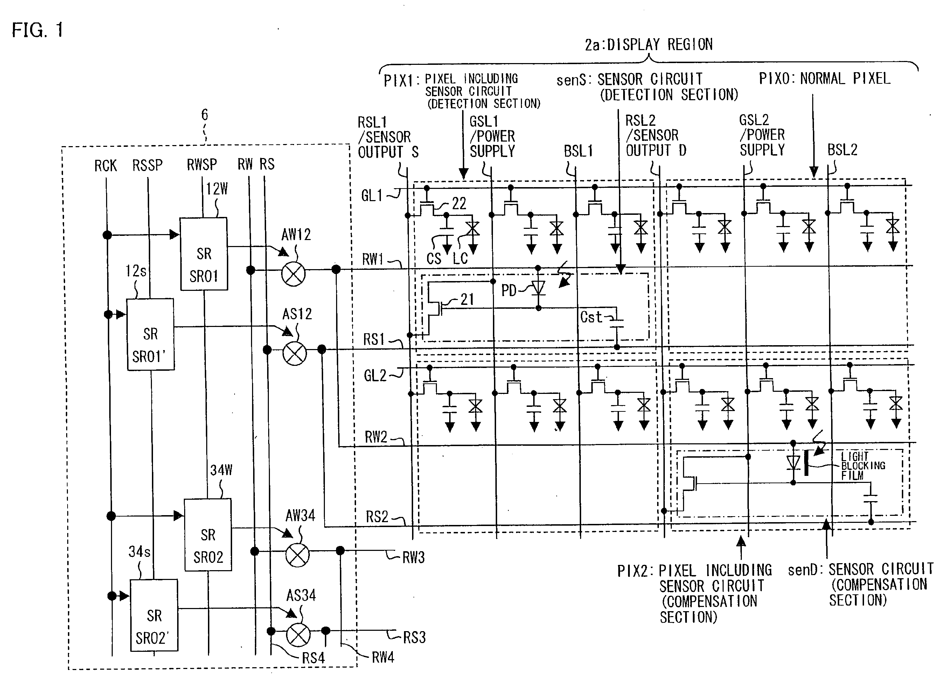

Fig. 1 a drawing illustrating an embodiment of a display device of the present invention in which planar configurations of pixels respectively including photosensor circuits and a configuration of a sensor row driver are shown.
Fig. 2

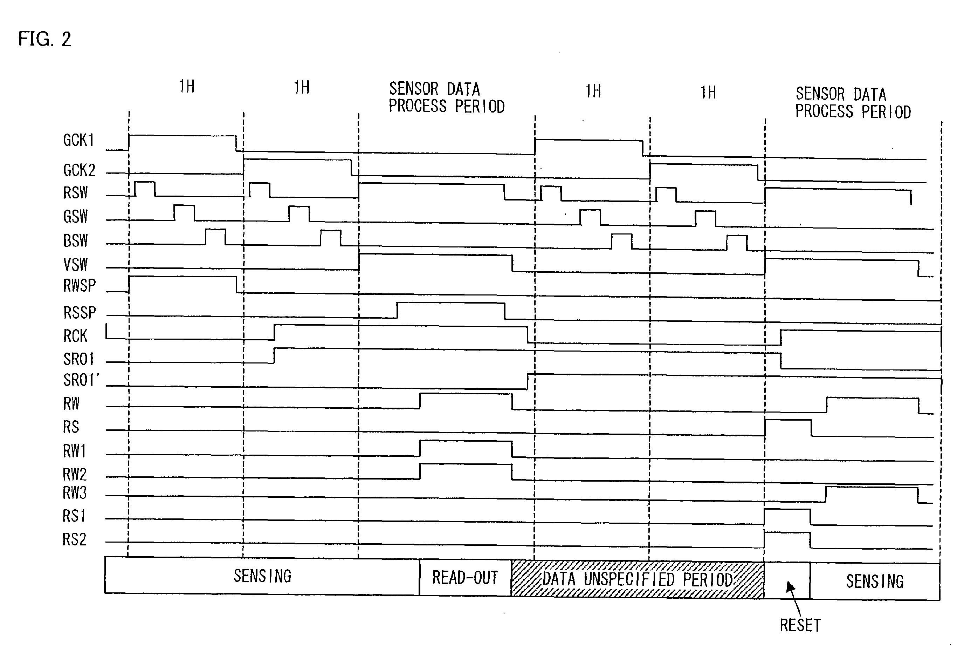

Fig. 2 is a timing chart describing an operation of the display device of Fig. 1.
Fig. 3

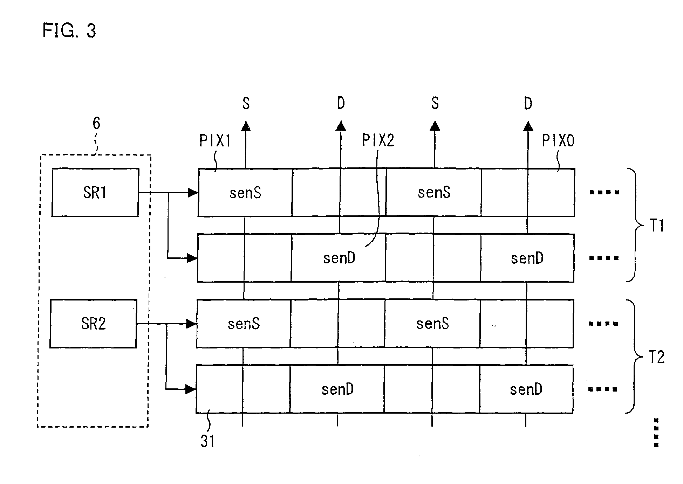

Fig. 3 is a block diagram of an embodiment of the present invention illustrating a layout pattern of photosensor circuits.
Fig. 4

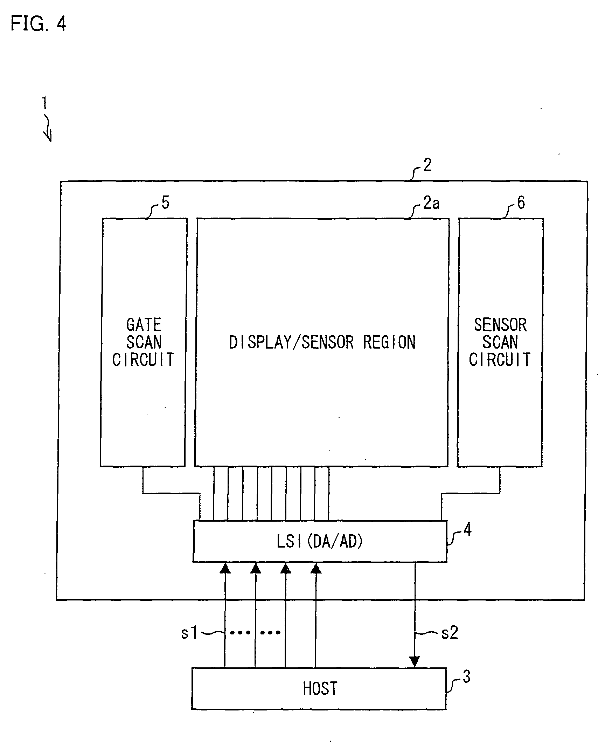

Fig. 4 is a block diagram of an embodiment of the present invention illustrating a configuration of a display device.
Fig. 5

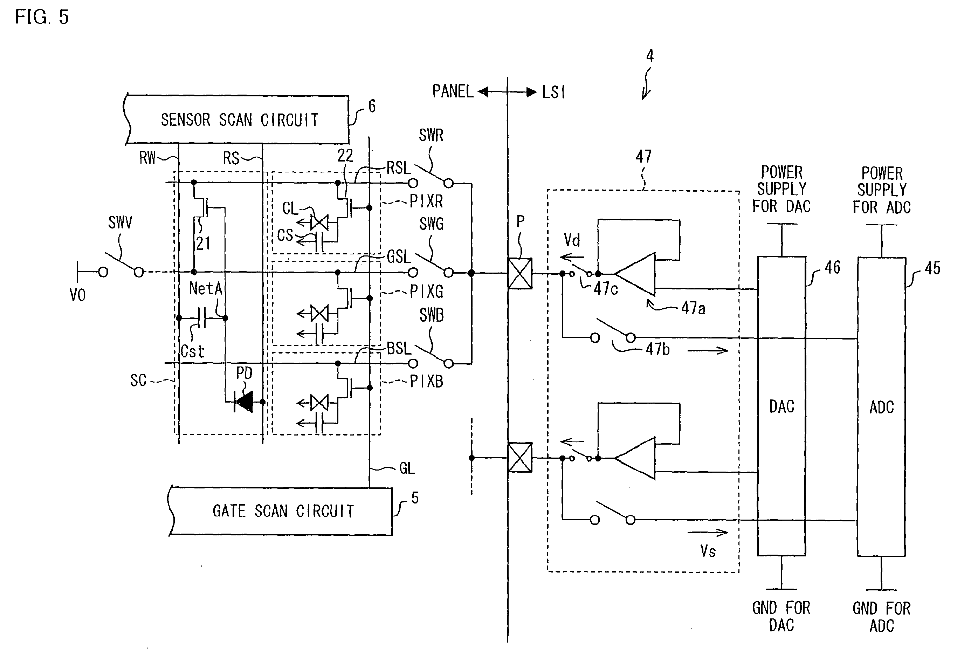

Fig. 5 is a circuit block diagram illustrating a configuration of a display panel included in the display device of Fig. 4.
Fig. 6

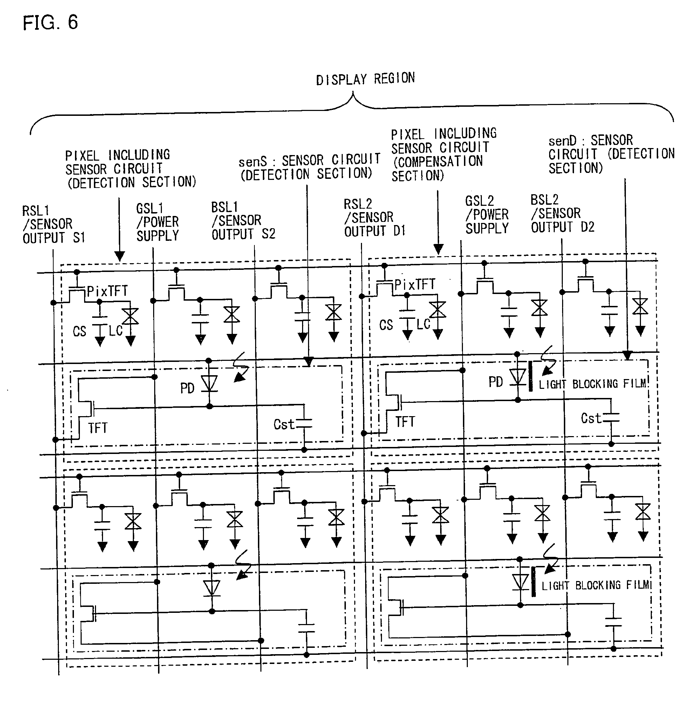

Fig. 6 is a drawing of an embodiment of the present invention illustrating another configuration example of picture element areas in a case where a predetermined number of picture elements is three.
Fig. 7

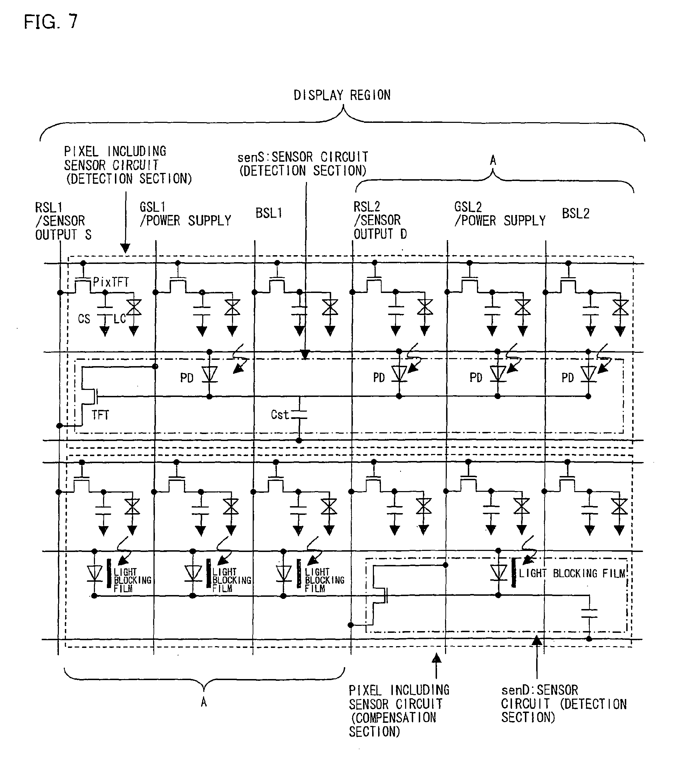

Fig. 7 is a drawing of an embodiment of the present invention illustrating a configuration example of picture element areas in a case where another number is employed as a predetermined number of picture elements.
Fig. 8

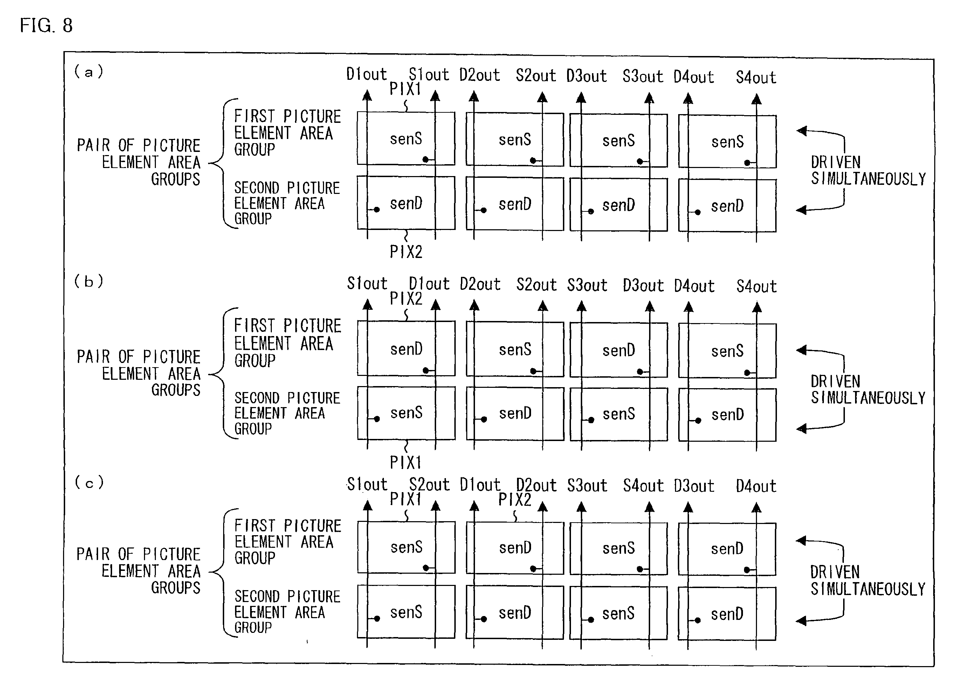

Fig. 8 is a block diagram illustrating an embodiment of the present invention in which other layout patterns of the photosensor circuits are shown. (a) to (c) of Fig. 8 show different configuration examples, respectively.
Fig. 9
Fig. 9 is a circuit block diagram of a conventional technique illustrating a configuration of a display device including a photosensor.
Fig. 10
Fig. 10 is a circuit diagram of a conventional technique illustrating a configuration of a photosensor circuit.
Fig. 11
Fig. 11 is a timing chart showing an operation of the photosensor circuit of Fig. 10.
Fig. 12
Fig. 12 is a block diagram of a conventional technique illustrating a layout pattern of photosensor circuits.
Fig. 13
Fig. 13 is a cross sectional view of a conventional technique illustrating a structure of a photosensor for photodetection.

Fig. 14
Fig. 14 is a cross sectional view of a conventional technique illustrating a structure of a photosensor for dark current detection.
Fig. 15
Fig. 15 is a block diagram of a conventional technique illustrating a configuration of a sensor row driver.
Fig. 16
Fig. 16 is a timing chart showing a configuration of the sensor row driver of Fig. 15.

Description of Embodiments

The following describes an embodiment of the present invention with reference to Figs. 1 to 8.

Fig. 4 shows a configuration of a liquid crystal display device 1 (display device) according to the present embodiment.

The liquid crystal display device 1 is an active matrix liquid crystal display device having a display panel 2 and a host controller 3.

The display panel 2 includes a display/sensor region 2a, a source driver 4 (data signal line drive circuit), a gate scan circuit 5 (scanning signal line drive circuit), and a sensor scan circuit (sensor row driver) 6. The sensor scan circuit 6 may be integrated with the gate scan circuit 5. The display/sensor region (display region) 2a of the display panel 2 is a region in which picture elements are formed in matrix by use of amorphous silicon, polysilicon, CG (Continuous Grain) silicon, microcrystal silicon, or the like. The display/sensor region (display region) 2a includes a matrix of pixels and sensor circuits SC which are shown in Fig. 5 to be described. The source driver 4 is configured such that LSI chips are directly mounted on the display panel 2, and thus has a so-called COG (Chip On Glass) configuration. The source driver 4 supplies data signals to data signal lines and consequently to the display/sensor region 2a, and processes outputs from sensor circuits SC. The gate scan circuit 5 supplies gate lines (scanning signal lines) with scanning signals that are used for writing data signals in the pixels in the display/sensor region 2a. The sensor scan circuit 6 supplies the sensor circuits SC in the display/sensor region 2a with necessary voltages.

The host controller 3 is a control substrate provided outside the display panel 2 and supplies the source driver 4 with: (i) display data to be supplied to the source driver 4; (ii) a clock signal, a start pulse, and the like to be supplied to the gate scan circuit 5; and (iii) a clock signal, a start pulse, a power supply voltage, and the like to be supplied to the sensor scan circuit 6. Here, a case is described where these supply signals and supply voltage are supplied to the gate scan circuit 5 and the sensor scan circuit 6 via the source driver 4.

Fig. 5 shows a relation of connection between the display/sensor region 2a and the source driver 4.

In the display/sensor region 2a, each pixel is made up of a set of an R picture element PIXR, a G picture element PIXG, and a B picture element PIXB. As will be described later with reference to Figs. 1 to 3, the sensor circuits SC are arranged in such a manner that they are inserted in predetermined positions in an array of a plurality of pixels, i.e., in predetermined positions in an array of a plurality of picture elements. In each pixel, the picture element PIXR, the picture element PIXG, and the picture element PIXB are driven in a time-sharing manner during one horizontal period. Each of the picture elements is formed at an intersection of a gate line GL and a data signal line SL (RSL for R, GSL for G, and BSL for B), and a data signal is written into a liquid crystal capacitor CL by a TFT 22 which serves as a selection element. Between each picture element electrode and a storage capacitor line (not illustrated) is further formed a storage capacitor CS. The data signal line RSL is connected with a terminal P of the source driver 4 via a switch SWR. The data signal line GSL is connected with the same terminal P of the source driver 4 via a switch SWG. The data signal line BSL is connected with the same terminal P of the source driver 4 via a switch SWB. Note that colors of the picture elements are not limited to the above three colors such as R, G, and B, and the picture elements may have any colors.

Each of the sensor circuits SC includes an n-channel amplifying TFT 21, a capacitor Cst, and a photosensor PD, which are equivalent to those in Fig. 10. As will be described later, the sensor circuits SC are either sensor circuits senS which serve as photodetecting sensors or sensor circuits senD which serve as dark current detection circuits.

A drain terminal of the amplifying TFT 21 is connected to the data signal line GSL, and a source terminal of the amplifying TFT 21 is connected to the data signal line RSL. The capacitor Cst and the photosensor PD are serially connected with each other at a connection point on a cathode side of the photosensor PD. The connection point, a node NetA, is connected to a gate of the amplifying TFT 21. The other end of the capacitor Cst is connected to the sensor scan circuit 6 via a read-out line RW (which is equivalent to the row select line RS in Fig. 9) provided in each pixel row. An anode of the photosensor PD is connected to the sensor scan circuit 6 via a reset line RS (which is equivalent to the reset line RST in Fig. 9) provided in each picture element row. The read-out line RW of each picture element row is connected with the aforementioned other ends of all the capacitors Cst in the picture element row. The reset line RS of each picture element row is connected with the anodes of all the photosensors PD provided in the picture element row. Further, the data signal line GSL is also connected to a power supply V0 via a switch SWV.

In the source driver 4, outputs of a source input/output circuit 47 are connected to the terminals P, respectively.

The source input/output circuit 47 includes stages each made up of a set of a buffer 47a that is composed of a voltage follower of an operational amplifier, a switch portion 47b, and a switch portion 47c. The stages are respectively connected to the aforementioned terminals P. An input of the buffer 47a is connected to an output of a DA converting circuit 46, and an output of the buffer 47a is connected to the terminal P via the switch portion 47c. The switch portion 47b is a circuit which switches between connection and disconnection of the input of the AD converting circuit 45 and the terminal P. The switch portion 47c is a circuit which switches between connection and disconnection of the output of the buffer 47a and the terminal P. The DA converting circuit 46 is provided with a power supply and GND for the DA converting circuit 46. The AD converting circuit 45 is provided with a power supply and GND for the AD converting circuit 45.

During a display period in which display is performed in the display/sensor region 2a by the picture elements, the buffer 47a is turned on, and the switch portion 47c connects the output of the buffer 47a to the terminal P. The switch portion 47b disconnects the input of the AD converting circuit 45 from the terminal P. This supplies the source outputs (data signals) Vd of R, G, and B to the display/sensor region 2a in a chronological order. In the display/sensor region 2a, the switches SWR, SWG, and SWB are alternately turned on, thereby supplying the source outputs Vd sequentially to the data signal lines RSL, GSL, and BSL so as to perform display operation in the picture elements PIXR, PIXG, and PIXB. Here, the switch SWV is in an off status.

During a sensor drive period in which the light intensity of irradiated external light and the dark current are detected in the display/sensor region 2a, the switch SWR is turned on, the switches SWG and SWB are turned off, and the switch SWV is turned on to connect the data signal line GSL to the power supply V0. Further, in a same manner as in Fig. 11, the capacitor Cst is charged in advance to a predetermined voltage in a forward direction of the photosensor PD from the sensor scan circuit 6, so that a voltage at the gate of the amplifying TFT 21 corresponds to the intensity of light irradiating the photosensor PD during the light intensity detection period. This allows supplying a voltage in accordance with the light intensity thus found to the data signal line RSL and, via the switch SWR, to the terminal P of the source driver 4.

Here, in the source driver 4, the switch portion 47c is turned off, and the switch portion 47b connects the input of the AD converting circuit 45 to the terminal P. In consequence, a sensor voltage Vs, which serves as an analog output of the sensor circuit SC, is supplied to the AD converting circuit 45. The AD converting circuit 45 converts the supplied sensor voltage Vs to digital data. The digital data is used in a subsequent process circuit as a detection result of the light intensity.

As described above, the source driver 4 functions as a light intensity finding means that finds the intensity of the light irradiating the photosensors PD.

Now, Fig. 3 shows a layout example of the sensor circuits SC in the display/sensor region 2a.

As described with reference to Fig. 12, two types of sensor circuits, i.e., (i) photodetection circuits senS that perform detection of the irradiated light and output detection outputs on the detection and (ii) dark current detection circuits senD that perform detection of the dark current and output detection outputs on the detection are provided as the sensor circuits SC, so that the detection outputs from the photodetection circuits senS are compensated by the detection outputs from the dark current detection circuits senD, thereby allowing a correct intensity of the irradiated light to be found.

The photodetection circuit senS is disposed in a region of the first pixel (picture element area, first picture element area) PIX1 made up of a first predetermined number of picture elements arranged in one picture element row. As illustrated in Fig. 1, the pixel PIX1 here is made up of three picture elements of R, G, and G. That is, the first predetermined number is three. The dark current detection circuit senD is disposed in a region of the second pixel (picture element area, second picture element area) PIX2 made up of a second predetermined number of picture elements arranged in one picture element row. As illustrated in Fig. 1, the pixel PIX2 here is made up of three picture elements of R, G, and B. That is, the second predetermined number is three and equal to the first predetermined number.

Thus, two types of detection picture element areas, i.e., the first pixels PIX1 and the second pixels PIX2, are located in the display/sensor region 2a.

Here, all the first pixels PIX1 provided in one of two adjacent picture element rows 31 constitute a first picture element area group, and all the second pixels PIX2 provided in the other one of the two adjacent picture element rows 31 constitute a second picture element area group. The first picture element area group and the second picture element area group make up a pair of picture element area groups T (in Fig. 3, T1, T2, ...). One pair of picture element area groups T includes both the first pixels PIX1 and the second pixels PIX2 as the detection picture element areas. One of the picture element rows 31 included in the pair of picture element area groups T is provided with just the first pixels PIX1 that include the censor circuits senS and are arranged at every second pixel so as to configure the first picture element area group. The other one of the picture element rows 31 is provided with just the second pixels PIX2 that include the sense circuits senD and are arranged at every second pixel so as to configure the second picture element area group.

In the pairs of picture element area groups T, outputs of detection signals including all of (i) outputs of the photodetection signals, which are detection signals of the photodetection circuits of the first pixels PIX1, and (ii) outputs of the dark current detection signals, which are detection signals of the dark current detection circuits of the second pixels PIX2, are respectively connected to different data signal lines RSL (in Fig. 1, RSL1, RSL2, ...) that serve as output lines of the detection signals. The output lines pass through a plurality of detection picture element areas arranged in a column direction. That is, here, the first pixels PIX1 and the second pixels PIX2 are diagonally adjacent to each other in each pair of picture element area groups T. Further, as illustrated in Fig. 5, the data signal line GSL (in Fig. 1, GSL 1, GSL 2, ...) is connected to the power supply V0 via the switch SWV and used as a power supply line for outputting detection signals of the first pixels PIX1 and the second pixels PIX2.

Pixels that are neither the first pixels PIX1 nor the second pixels PIX2 serve as normal pixels PIX0 in which no photosensor circuits are disposed (however, read-out lines RW and reset lines RS are provided).

Note that different layout patterns of the first pixels PIX1 and the second pixels PIX2 than the above-described example are also possible. The examples are shown in (a) to (c) of Fig. 8.

In (a) of Fig. 8, the first picture element area group is made up only of the first pixels PIX1, and the second picture element area group is made up only of the second pixels PIX2. In the picture element row including the first picture element area group, the first pixels PIX1 are neighboring. In the picture element row including the second picture element area group, the second pixels PIX2 are neighboring. One output line Sout (in the drawing, S1out, S2out, ...) of the photodetection signals and one output line Dout (in the drawing, D1out, D2out, ...) of the dark current detection signals are passed through in each column in which the detection picture element areas are arranged in the column direction.

In (b) of Fig. 8, the first picture element area group is configured in such a manner that the first pixels PIX1 and the second pixels PIX2 are alternately located, and the second picture element area group is configured in such a manner that the second pixels PIX2 and the first pixels PIX1 are alternately located. In each pair of picture element area groups, the first pixels PIX1 and the second pixels PIX2 are aligned in a column direction. One output line Sout (in the drawing, S1out, S2out, ...) of the photodetection signals and one output line Dout (in the drawing, D1out, D2out, ...) of the dark current detection signals are passed through in each column in which the detection picture element areas are arranged in the column direction.

In (c) of Fig. 8, the first picture element area group is configured in such a manner that the first pixels PIX1 and the second pixels PIX2 are alternately located, and the second picture element area group is configured in such a manner that the first pixels PIX1 and the second pixels PIX2 are alternately located. In each pair of picture element area groups, (i) columns of the detection picture element areas in which the first pixels PIX1 are arranged in a column direction and (ii) columns of the detection picture element areas in which the second pixels PIX2 are arranged in a column direction are alternately located. Two output lines Sout (in the drawing, S1out and S2out, S3out and S4out, ...) of the photodetection signals are passed through in each column in which the first pixels PIX1 are arranged in the column direction, and two output lines Dout (in the drawing, D1out and D2out, D3out and D4out, ...) of the dark current detection signals are passed through in each column in which the second pixels PIX2 are arranged in the column direction. In each pair of picture element area groups, one of two output lines Sout and one of two output lines Dout are connected to the first picture element area group. The other ones are connected to the second picture element area group.

As shown in Fig. 1, the sensor scan circuit 6 sequentially supplies each pair of picture element area groups T with read-out signals RW (in Fig. 1, RW1, RW2, ...) that cause the photodetection signals of the first pixels PIX1 and the dark current detection signals of the second pixels PIX2 to be simultaneously outputted. For this operation, the sensor scan circuit 6 includes a first shift register made up of shift register stages 12W, 34W, 56W, ....

Further, as shown in Fig. 1, the sensor scan circuit 6 includes a second shift register that sequentially supplies each pair of picture element area groups T with reset signals RS (in Fig. 1, RS1, RS2, ...) that initialize the detection operations of the first pixels PIX1 and the second pixels PIX2. The second shift register is made up of shift register stages 12S, 34S, 56S, .... As such, two cascades of shift registers are used here.

Each of the first shift register and the second shift register performs shift operations in response to clock signals RCK. In the first shift register, after a shift of a start pulse RWSP, sequential shift outputs SRO1, SRO2, ...from the shift register stages 12W, 34W, ... cause switches AW12, AW34, ... to be sequentially turned on. Then, high read-out signals RW are sequentially supplied as read-out signals RW1 and RW2, RW3 and RW4, ...to read-out signal supply lines. Note that the read-out signals RW supplied to one pair of picture element area groups are, as shown by RW1 and RW2 in a timing chart of Fig. 2, for example, signals obtained via one switch AW that is turned on by the shift output of one shift register stage.

In the second shift register, after a shift of a start pulse RSSP, sequential shift outputs from the shift register stages 12S, 34S, ... cause switches AS12, AS34, ... to be sequentially turned on. Then, high reset signals RS are sequentially supplied as reset signals RS1 and RS2, RS3 and RS4, ... to reset lines RS. Note that the reset signals RS supplied to one pair of picture element area groups are, as shown by RS1 and RS2 in the timing chart of Fig. 2, for example, signals obtained via one switch AS that is turned on by the shift output of one shift register stage.

For ease of explanation, circuits that select output paths for the read-out signals RW and the reset signals RS are described here as switches AW and AS. In a real circuit, however, even if the switches are turned off, the circuits are not floated and predetermined potentials are outputted, respectively.

The timing chart of Fig. 2 shows timings of signals of the first shift register and the second shift register as well as timings of signals of the gate scan circuit 5. During 1H (one horizontal period) of display which period is defined by gate clock signals GCK1, GCK2, ..., switches SWR, SWG, and SWB in Fig. 5 are respectively and sequentially supplied with video sampling signals RSW, GSW, and BSW, and an SSD (Source Shared Driving) is carried out. Sensing by the sensor circuits is carried out in large part during this display selection period. During a sensor data process period that is set except during the display selection period, a control signal VSW that turns on the switch SWV in Fig. 5 becomes active to cause read-out and reset to be performed. The output of the reset signals RS1, RS2, ... precedes the read-out by one frame period, the read-out being carried out in response to corresponding read-out signals RW1, RW2, ....

As such, the sensor row driver allows outputs of detection signals of all the photodetection circuits and the dark current detection circuits included in the pair of picture element area groups to be simultaneously obtained via different output lines. Accordingly, the light intensity finding means can compensate the outputs of the detection signals of the photodetection circuits by use of the outputs of the detection signals of the dark current detection circuits that are simultaneously obtained.

As described above, according to the present embodiment, the first picture element area group and the second picture element area group of each pair of picture element groups are simultaneously driven, and detection outputs of the photosensor circuits are simultaneously obtained from the first picture element area group and the second picture element area group. This makes it possible to obtain two pieces of data with small variations between the first picture element area group and the second picture element area group, which variations are caused by time difference. It is further possible to obtain data with smaller variations by averaging detection outputs that are simultaneously obtained from a plurality of picture element areas having the same structures.

Unlike a case where the first picture element area group and the second picture element area group are alternately driven for one period in turn, in each pair of picture element area groups, one operation is carried out for two drive periods. This can ensure a long read-out time together with a long reset period for the photosensor circuit. As such, it is possible to suppress variations in detection.

By combining the two pieces of data thus obtained with each other, one of the two pieces of data can be exactly corrected by the other. For example, a photodetection result can be correctly compensated by a dark current detection result.

The above configuration can realize such a display device including a photosensor circuit that can exactly correct the photodetection result in which different types of data are combined. For example, the display device can carry out a correct compensation for photodetection.

Further, the sensor row driver sequentially supplies the read-out signal to each pair of picture element area groups including two types of detection picture element areas, which are the first picture element area type and the second picture element area type, so as to cause the pair of picture element area groups to simultaneously output the photodetection signal of the first picture element area type and the dark current detection signal of the second picture element area type, respectively. In each pair of picture element area groups, the detection signals are supplied to the output lines and obtained. The output lines are provided so as to be connected with a plurality of the detection picture element areas arranged in a column direction. The detection signals thus obtained are detected by the light intensity finding means to find the intensity of light irradiation.

Accordingly, it is possible to perform a correct compensation for photodetection by use of a photodetection signal and a dark current detection signal that are simultaneously obtained and have small variations.

Further, each shift register stage of the first shift register is commonly used for two picture element rows. As a result, it becomes possible to decrease a circuit scale of the first shift register by half. In consequence, the configuration of the present embodiment makes a contribution to allowing the display device to have a slim picture frame.

The above described embodiment is exemplified by a configuration in which one sensor circuit SC is provided for one pixel made up of three picture elements of R, G, and B. However, the present invention is not limited thereto, and the sensor circuit SC may be provided for any number of pixels. For instance, one sensor circuit SC may be provided for one or a plurality of pixels. Further, in aforementioned (c) of Fig. 8, in a case where a picture element area is realized whose predetermined number of the picture elements is three, the data signal line RSL and the data signal line BSL may also serve as the output lines, respectively, as in Fig. 6. In that case, however, it is necessary to provide another path in the panel and the LSI for receiving a sensor output from the data signal line BSL.

Fig. 7 shows a case where the predetermined number of the picture elements is different from that in the above-described example (Fig. 7 shows an example in which one pixel is made up of six picture elements). In this configuration, even if the normal pixels PIX0 are provided with photodiodes or the like, as in the region A, it is possible to cause the photodetection circuits and the dark current detection circuits in the pair of picture element area groups to simultaneously supply detection outputs. Accordingly, the photodetection result in which different types of data are combined can be exactly corrected, and by use of the photodetection signal and the dark current detection signal that are simultaneously obtained and have small variations, it is possible to perform a correct compensation for photodetection.

Further, as already described with reference to Fig. 8, the first pixels PIX1 and the second pixels PIX2 of the different pairs of picture element area groups T may be connected to the same output line in a mixed manner. The first pixels PIX1 and the second pixels PIX2 may also be arranged in the same picture element row in a mixed manner. Further, a configuration is also possible in which the detection picture element areas (in the above example, the first pixels PIX1 and the second pixels PIX2) are arranged in only one of the picture element rows included in one pair of picture element area groups T.

Moreover, the configuration of the sensor circuit SC is not limited to the foregoing example, and any configuration is possible. For instance, a photosensor PD constituted by diode-connected TFTs and a plurality of photosensors PD connected in parallel or in series may be used. It is also possible to dispose a plurality of capacitors Cst in a dispersed manner in the sensor circuit region.

The type of the display device is not limited to the liquid crystal display device. The present invention can be applied to other display devices such as an EL display panel.

The present invention is not limited to the description of the embodiments above, but may be altered within the scope of the claims. An embodiment based on a proper combination of technical means disclosed in different embodiments is encompassed in the technical scope of the present invention.

Industrial Applicability

The present invention can preferably be used in a display panel including a fingerprint authentication technique and a touch panel that use a photosensor.

Reference Signs List

| | |
|---|---|
| 1 | Liquid Crystal Display Device (Display Device) |
| 2a | Display/Sensor Region (Display Region) |
| 4 | Source Driver (Light Intensity Finding Means) |
| 6 | Sensor Scan Circuit (Sensor Row Driver) |
| T | Pair of Picture Element Area Groups |
| PD | Photosensor |
| SC | Sensor Circuit (Photosensor Circuit) |
| senS | Photodetection Circuit |
| senD | Dark Current Detection Circuit |
| PIX1 | First Pixel (Picture Element Area, First |
| Picture Element Area, | Detection Picture Element Area) |
| PIX2 | Second Pixel (Picture Element Area, Second |
| Picture Element Area, | Detection Picture Element Area) |
| RSL | Data Signal Line (Output Line) |
| GSL | Data Signal Line (Power Supply Line) |
| RW | Read-out Signal |
| RS | Reset Signal |

**Claims**

1. A display device comprising a display region in which a plurality of picture elements are arranged in matrix, wherein:

picture element areas are formed in the display region, wherein the each picture element area includes a predetermined number of picture elements on an identical row and is provided with a photosensor for outputting a detection signal indicative of intensity of irradiated light irradiated on the photosensor;
at least one pair of picture element area groups is provided, wherein one of the picture element area groups is a first picture element area group and includes picture element areas on one row, and the other one of the picture element area groups is a second picture element area group and includes picture element areas on another row; and
each of the at least one pair of picture element area groups is paired such that it is possible to drive the first picture element area group and the second picture element area group simultaneously, and it is possible to output the detection signals of the first picture element area group and the detection signals of the second picture element area group simultaneously.

2. The display device according to claim 1, wherein:
the plurality of picture element areas include detection picture element areas of two types, one of which is a first picture element area type including a photodetection circuit which serves as a photosensor circuit having a photosensor that outputs, as the detection signal, a photodetection signal indicative of intensity of irradiated light irradiated on the photosensor, the photodetection circuit being disposed in a region including a first predetermined number of picture elements, and the other one of which is a second picture element area type including a dark current detection circuit which serves as a photosensor circuit having a photosensor that outputs, as the detection signal, a dark current detection signal of the photosensor, the dark current detection circuit being disposed in a region including a second predetermined number of picture elements,
the detection signals of the detection picture element areas are outputted via output lines each passing the detection picture element areas aligned in column directions;
the display device further comprises light intensity finding means for finding the intensity of the irradiated light by detecting the detection signal of the detection picture element area, the detection signal being supplied to the light intensity finding means via the output line;
the at least one pair of the picture element area groups includes both the first picture element area type and the second picture element area type;
a sensor row driver for sequentially supplying the at least one pair of picture element area groups with a read-out signal for causing the picture element areas of the first picture element area type and the picture element areas of the second picture element area type to simultaneously output the photodetection signal and the dark current detection signal, respectively; and
the at least one pair of picture element area groups is such that one of the picture element area groups and the other one of the picture element area groups are connected with different ones of the output lines, respectively.

3. The display device according to claim 2, wherein the detection picture element areas are arranged in the display region so as not to be adjacent to each other in both a row direction and a column direction.

4. The display device according to claim 2 or 3, wherein the detection picture element areas of the first picture element area type and the detection picture element areas of the second picture element area type are adjacent to each other in a diagonal direction in each of the at least one pair of picture element area groups.

5. The display device according to any one of claims 2 to 4, wherein the first predetermined number and the second predetermined number are equal to each other.

6. The display device according to claim 5, wherein the first predetermined number of picture elements and the second predetermined number of picture elements are 3 and the picture elements are respectively three picture elements of R, G, and B.

7. The display device according to any one of claims 2 to 6, wherein each of the output lines is a data signal line connected to one of each picture element included in that one of the detection picture element areas which corresponds to the output line.

8. The display device according to claim 7, wherein:

each of the detection picture element areas includes more than one picture element, and
each of the detection picture element areas is such that another one of the picture elements included therein is connected with a data signal line serving as a power supply line for outputting the detection signal of the detection picture element area.

9. The display device according to any one of claims 2 to 8, wherein the sensor row driver includes a first shift register for sequentially supplying each of the at least one pair of the picture element area groups with the read-out signal.

10. The display device according to claim 9, wherein the first shift register causes switches corresponding to respective shift register stages to be turned on in response to outputs of the respective shift register stages, so that the each of the at least one pair of picture element area groups is sequentially supplied with the read-out signal via corresponding one of the switches.

**11.** The display device according to claim 9 or 10, wherein the sensor row driver includes a second shift register for sequentially supplying each of the at least one pair of the picture element area groups with a reset signal, the reset signal initializing a detection operation of the detection picture element areas.

**12.** The display device according to claim 11, wherein the second shift register causes switches corresponding to respective shift register stages to be turned on in response to outputs of the respective shift register stages, so that the each of the at least one pair of picture element area groups is sequentially supplied with the read-out signal via corresponding one of the switches.

FIG. 1

FIG. 2

EP 2 333 643 A1

FIG. 3

FIG. 4

FIG. 5

POWER SUPPLY FOR ADC — ADC — GND FOR ADC — 45

POWER SUPPLY FOR DAC — DAC — GND FOR DAC — 46

4

47

47a

47b

47c

Vd

Vs

LSI

PANEL

P

SWR

RSL   PIXR   SWG

GSL   PIXG   SWB

BSL   PIXB

GL   5

GATE SCAN CIRCUIT

SENSOR SCAN CIRCUIT — 6

22

CL   CS

RS

21   NetA   PD

Cst

SC

RW

SWV

V0

# EP 2 333 643 A1

FIG. 6

DISPLAY REGION

PIXEL INCLUDING SENSOR CIRCUIT (DETECTION SECTION)

senS : SENSOR CIRCUIT (DETECTION SECTION)

PIXEL INCLUDING SENSOR CIRCUIT (COMPENSATION SECTION)

senD : SENSOR CIRCUIT (DETECTION SECTION)

RSL1 /SENSOR OUTPUT S1

GSL1 /POWER SUPPLY

BSL1 /SENSOR OUTPUT S2

RSL2 /SENSOR OUTPUT D1

GSL2 /POWER SUPPLY

BSL2 /SENSOR OUTPUT D2

PixTFT

CS LC

PD

LIGHT BLOCKING FILM

TFT

Cst

LIGHT BLOCKING FILM

20

FIG. 7

DISPLAY REGION

PIXEL INCLUDING
SENSOR CIRCUIT
(DETECTION SECTION)

senS:SENSOR CIRCUIT
(DETECTION SECTION)

A

RSL1
/SENSOR
OUTPUT S

GSL1
/POWER SUPPLY

BSL1

RSL2
/SENSOR
OUTPUT D

GSL2
/POWER SUPPLY

BSL2

PixTFT

CS  LC

PD

PD

PD

PD

TFT

Cst

LIGHT
BLOCKING
FILM

LIGHT
BLOCKING
FILM

LIGHT
BLOCKING
FILM

LIGHT BLOCKING FILM

A

PIXEL INCLUDING
SENSOR CIRCUIT
(COMPENSATION
SECTION)

senD:SENSOR
CIRCUIT (DETECTION
SECTION)

21

FIG. 8

(a)

D1out  S1out  D2out  S2out  D3out  S3out  D4out  S4out

PAIR OF PICTURE ELEMENT AREA GROUPS
{
FIRST PICTURE ELEMENT AREA GROUP

PIX1

senS    senS    senS    senS

SECOND PICTURE ELEMENT AREA GROUP

senD    senD    senD    senD

PIX2

DRIVEN SIMULTANEOUSLY

(b)

S1out  D1out  D2out  S2out  S3out  D3out  D4out  S4out

PAIR OF PICTURE ELEMENT AREA GROUPS
{
FIRST PICTURE ELEMENT AREA GROUP

PIX2

senD    senS    senD    senS

SECOND PICTURE ELEMENT AREA GROUP

senS    senD    senS    senD

PIX1

DRIVEN SIMULTANEOUSLY

(c)

S1out  S2out  D1out  D2out  S3out  S4out  D3out  D4out

PAIR OF PICTURE ELEMENT AREA GROUPS
{
FIRST PICTURE ELEMENT AREA GROUP

PIX1    PIX2

senS    senD    senS    senD

SECOND PICTURE ELEMENT AREA GROUP

senS    senD    senS    senD

DRIVEN SIMULTANEOUSLY

EP 2 333 643 A1

FIG. 9

FIG. 10

Vrs          Vrw          Vdd

A

Cst

C

NetA

21

Vout

PD

I

FIG. 11

Vrs
0
−10

Vdd
20
15

Vrw
0

VnetA
0
DARK
BRIGHT
DARK
BRIGHT

Vout
DARK
BRIGHT

T1      T2

t1    t2          t3    t4

FIG. 12

FIG. 13

PHOTODETECTION CIRCUIT

FIG. 14

DARK CURRENT DETECTION CIRCUIT

EP 2 333 643 A1

FIG. 15

28

FIG. 16

| **INTERNATIONAL SEARCH REPORT** | International application No. |
| --- | --- |
| | PCT/JP2009/060551 |

A.  CLASSIFICATION OF SUBJECT MATTER
*G06F3/041*(2006.01)i, *G02F1/133*(2006.01)i, *G09G3/20*(2006.01)i, *G09G3/36* (2006.01)i, *H01L31/10*(2006.01)i, *H04N5/335*(2006.01)i

According to International Patent Classification (IPC) or to both national classification and IPC

B.  FIELDS SEARCHED

Minimum documentation searched (classification system followed by classification symbols)
G06F3/041, G02F1/133, G09G3/20, G09G3/36, H01L31/10, H04N5/335

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | JP 2008-203504 A  (Hitachi Displays, Ltd.),<br>04 September, 2008 (04.09.08),<br>Par. Nos. [0014] to [0035]; Figs. 1 to 8<br>& US 2008/0198143 A1 | 1<br>2-12 |
| Y | JP 2007-011233 A  (Toshiba Matsushita Display Technology Co., Ltd.),<br>18 January, 2007 (18.01.07),<br>Full text; Figs. 4, 5<br>(Family: none) | 2-12 |

| ☐    Further documents are listed in the continuation of Box C. | ☐    See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>13 August, 2009 (13.08.09) | Date of mailing of the international search report<br>25 August, 2009 (25.08.09) |
| --- | --- |
| Name and mailing address of the ISA/<br>Japanese Patent Office | Authorized officer |
| Facsimile No. | Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007145347 A
- JP 1164165 A
- JP 2007047991 A